**Europäisches Patentamt**

(19) **European Patent Office**

**Office européen des brevets**

(11) Veröffentlichungsnummer: **0 109 524**
**B1**

(12) # EUROPÄISCHE PATENTSCHRIFT

(45) Veröffentlichungstag der Patentschrifft:
21.03.90

(51) Int. Cl. 5: **B 23 K 15/00**, G 05 B 19/415

(21) Anmeldenummer: 83110054.0

(22) Anmeldetag: 08.10.83

(54) Verfahren und Anordnung zum Bearbeiten eines Werkstücks mittels eines fokussierten Elektronenstrahls.

(30) Priorität: 22.11.82 DE 3243033

(43) Veröffentlichungstag der Anmeldung:
30.05.84 Patentblatt 84/22

(45) Bekanntmachung des Hinweises auf die Patenterteilung:
21.03.90 Patentblatt 90/12

(84) Bennante Vertragsstaaten:
DE FR GB

(56) Entgegenhaltungen:
WO-A-82/02352
DE-B-2 937 646
DE-C-3 043 635
US-A-3 543 286
US-A-3 775 581

Die Akte enthält technische Angaben, die nach dem Eingang der Anmeldung eingereicht wurden und die nicht in dieser Patentschrift enthalten sind.

(73) Patentinhaber: Institut für Kerntechnik und Energiewandlung e.V.
Holderbuschweg 52
D-7000 Stuttgart 80 (DE)

(72) Erfinder: Koch, Dieter, Dr.-Ing.
Engelbergstrasse 40
D-7000 Stuttgart 31 (DE)

(74) Vertreter: Patentanwälte Dr. Ing. Eugen Maier Dr. Ing. Eckhard Wolf
Eugensplatz 5 Postfach 13 10 01
D-7000 Stuttgart 1 (DE)

EP 0 109 524 B1

LIBERGRAF, STOCKHOLM 1990

**Beschreibung**

Die Erfindung betrifft eine Anordnung zum Bearbeiten, insbesondere Schweißen eines Werkstücks mittels eines fokussierten Elektronenstrahls in einer Elektronenstrahlbearbeitungsmaschine, insbesondere einer Elektronenstrahl-Schweißmaschine, mit einem Bahnkurvengenerator zur Bewegung des Auftreffpunkts des Elektronenstrahls entlang einer Bahnkurve relativ zum Werkstück.

Es ist eine Anordnung dieser Art bekannt (US-A-3 775 581), bei der der Elektronenstrahl entlang einem Schweißspalt automatisch nachgeführt wird, dessen Verlauf eine Gerade, ein Kreis, ein Quadrat, eine Ellipse oder irgendwelche Variationen und Kombinationen dieser einfachen geometrischen Kurven bildet. Die vorgegebene Bahnkurve wird dort mit Hilfe eines durch einen Kreisgenerator erzeugten Abtaststrahls kreisend abgetastet. Die dabei von dem Reflexionssignal erhaltenen Impulse werden in Fehlerkoordinaten in einem mitbewegten X-Y-Koordinatensystem umgerechnet, die ihrerseits in digitaler Form abgespeichert werden können. Die Darstellung von komplizierteren Bahnkurven ist mit der bekannten Anordnung nicht möglich. Hierbei war man bisher auf Handbetrieb oder numerische Tischsteuerungen angewiesen.

Ausgehend hiervon liegt der Erfindung die Aufgabe zugrunde, eine Schaltungsanordnung zu entwickeln, mit der beliebige Bahnfiguren mit hoher Genauigkeit und Reproduzierbarkeit erzeugt werden können.

Zur Lösung dieser Aufgabe werden die in den Patentansprüchen 1 und 2 angegebenen Merkmalskombinationen vorgeschlagen. Weitere vorteilhafte Ausgestaltungen und Weiterbildungen der Erfindung ergeben sich aus den abhängigen Ansprüchen.

Die erfindungsgemäße Lösung geht von dem Gedanken aus, die Bahnkurve durch eine Folge von im Abstand voneinander angeordneten Stützpunkten vorzugeben und den Auftreffpunkt des Elektronenstrahls auf dem Weg zwischen zwei Stützpunkten entlang einer Verbindungslinie mit vorgebbarer Bahngeschwindigkeit zu bewegen. Damit können beliebige Bahnfiguren erzeugt werden. Es hat sich gezeigt, daß man selbst bei relativ komplizierten Bahnkurven mit recht wenigen Stützpunkten auskommt, wenn man berücksichtigt, daß die Stützpunkte je nach Krümmung der Bahnkurve mehr oder weniger dicht gelegt werden können. So werden z. B. für die Erzeugung einer vollständigen Kreisfigur mit einer Genauigkeit der Radiusabweichung von 1 % nur 16 Stützpunkte benötigt.

Es ist an sich bekannt, den Auftreffpunkt des Elektronenstrahls zusätzlich auf einer der Bahnkurve überlagerten Modulationskurve gegenüber der Bahnkurve abzulenken. Mit einer solchen Mikrobewegung des Elektronenstrahl während des Schweißvorgangs kann die Kapillardynamik eines Schweißbads und damit das Gefüge einer Schweißnaht maßgeblich beeinflußt werden.

Auch bei der automatischen Strahlnachführung ist eine Querablenkung des Elektronenstrahls zur Abtastung der Werkstückoberfläche erforderlich, um die Lageabweichung des Schweißspalts gegenüber einer vorgegebenen Bahnkurve messen zu können (DE-C-3 043 635).

Da die Modulationskurven regelmäßig in einem festen Koordinatensystem vorgegeben, beispielsweise analytisch erzeugt oder aus einem Datenspeicher ausgelesen werden, wird gemäß einer bevorzugten Ausgestaltung der Erfindung zu jedem Stützpunkt der Bahnkurve die Richtung der Verbindungslinie zum nächsten Stützpunkt oder deren Normalenrichtung vorgegeben oder berechnet, so daß die Modulationskurve im Verlauf der Bahnkurve in diese Richtung ausgerichtet werden kann.

Gemäß einer weiteren vorteilhaften Ausgestaltung der Erfindung bildet die Modulationskurve eine Abtastfigur, auf der der Auftreffpunkt des Elektronenstrahls in einem Meßzyklus quer zur Bahnkurve über das Werkstück bewegt wird. Damit kann ein die Lage einer Bearbeitungslinie auf dem Werkstück, insbesondere eines Schweißspalts, definierendes Positionssignal aufgefangen und dessen in Normalenrichtung gemessene Abweichung von der vorgegebenen Bahnkurve für jeden Stützpunkt abgespeichert und bei einem anschließenden Bearbeitungsvorgang stützpunktweise ausgelesen und der Bahnkurve in Normalenrichtung additiv überlagert wird.

Im folgenden wird die Erfindung anhand der Zeichnung näher erläutert. Es zeigen

Fig. 1 ein Blockschaltbild einer Schaltungsanordnung zur Ansteuerung der Ablenkverstärker einer Elektronenstrahlschweißmaschine;

Fig. 2 ein Blockschaltbild eines ersten Ausführungsbeispiels eines Bahnkurvengenerators;

Fig. 3 ein Blockschaltbild eines zweiten Ausführungsbeispiels eines Bahnkurvengenerators.

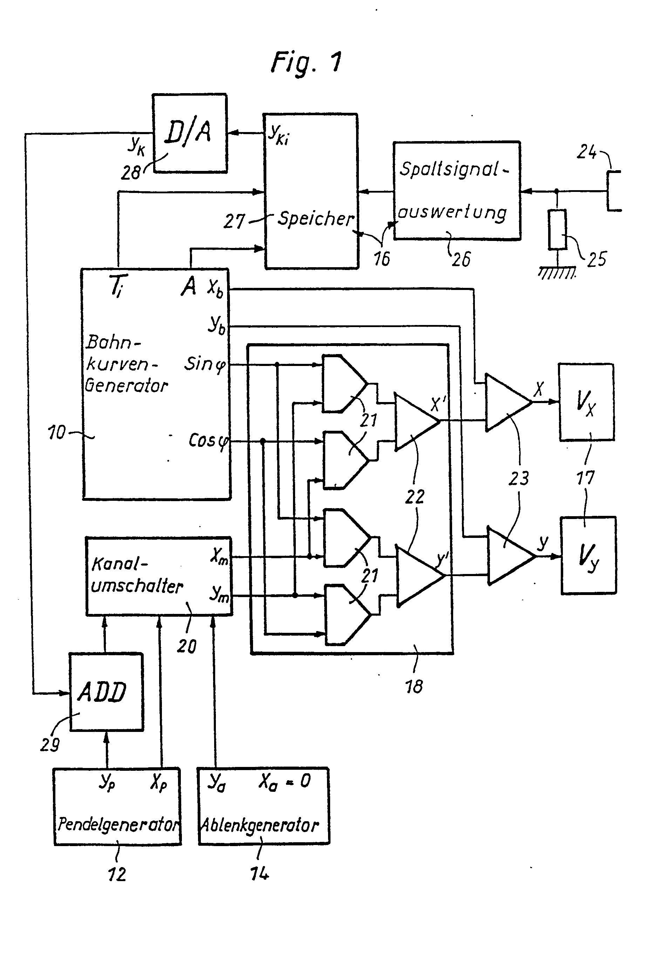

Die Schaltungsanordnung, deren Blockschaltbild in Fig. 1 dargestellt ist, umfaßt im wesentlichen einen Bahnkurvengenerator 10, einen aus einem Pendelgenerator 12 und einem Ablenkgenerator 14 bestehenden Modulationskurvengenerator, eine Strahlnachführungseinrichtung 16 sowie eine Schaltungsanordnung 18 zur Verknüpfung der analogen Ausgangssignale des Bahnkurvengenerators 10 des Modulationskurvengenerators 12,14 und der Strahlnachführungseinrichtung 16 für die Ansteuerung der beiden Ablenkverstärker 17 einer Elektronenstrahlschweißmaschine.

Vorstehend und nachfolgend werden die digitalen Koordinaten- und Richtungswerte der Bahnkurve und der Modulationskurven und die zugehörigen Analogsignale (Spannungen) der Übersichtlichkeit halber mit den gleichen Buchstaben bezeichnet.

Mit dem Bahnkurvengenerator 10 kann der Auftreffpunkt des Elektronenstrahls auf einem Werkstück mit einstellbarer Bahngeschwindigkeit auf einer zweidimensional vorgegebenen Bahnkurve bewegt werden. Mit Hilfe des Pendelgenerators 12 und des Ablenkgenerators 14 ist es möglich, der vom Elektronenstrahl beschriebenen Bahnkurve eine Modulationskurve zu überlagern, so daß zusätzlich eine von der vorgeschriebenen Bahnkurve abweichende Mikrobewegung ausgeführt wird. Da die vom Pendelgenerator 12 und vom Ablenkgenerator 14 abgegebenen Modulationskurvensignale $(x_p, y_p)$ bzw. $(x_a = 0, y_a)$ einem festen Koordinatensystem zugeordnet sind, ist eine Koordinatendreheinrichtung 18 vorgesehen, die dafür sorgt, daß die Modulationskurven immer in Richtung der Bahnkurvennormalen bzw. -tangente ausgerichtet werden, bevor sie der Bahnkurve überlagert werden.

Hierzu sind an den Ausgängen des Bahnkurvengenerators 10 neben den augenblicklichen Koordinatensignalen $x_b$ und $y_b$ die Richtungssignale $\sin\varphi$ und $\cos\varphi$ abgreifbar, wobei $\varphi$ den Richtungswinkel der Bahnkurvennormalen gegenüber der x-Achse des ortsfesten Koordinatensystems der Bahnkurve bedeutet.

Die Modulationskurvensignale $x_m$, $y_m$, die durch den zentralgesteuerten Kanalumschalter 20 aus den Koordinatensignalen $x_p$, $y_p$ des Pendelgenerators 12 bzw. $x_a = 0$, $y_a$ des Ablenkgenerators 14 auswählbar sind, werden zusammen mit den Richtungssignalen $\sin\varphi$ und $\cos\varphi$ paarweise an die Eingänge von vier Analogmultiplizierern 21 gelegt, deren Ausgangssignale in den beiden nachgeschalteten Analogaddierern 22 nach Maßgabe der folgenden Beziehungen unter Bildung eines bezüglich der Bahnkurvennormalen ausgerichteten Modulationssignal x', y' miteinander verknüpft werden:

$$x' = x_m \cos\varphi - y_m \sin\varphi$$
$$y' = x_m \sin\varphi + y_m \cos\varphi$$

Anstelle des Richtungswinkels $\varphi$ der Bahnnormalen kann auch der Richtungswinkel $\psi$ der Bahntangente für die Durchführung der Koordinatendrehung als Vorgabewert verwendet werden. In diesem Falle ist in der Koordinatendrehschaltung 18 folgende Signalverknüpfung durchzuführen:

$$x' = -x_m \sin\psi + y_m \cos\psi$$
$$y' = x_m \cos\psi + y_m \sin\psi$$

Die Ausgangssignale x' und y' der Koordinatendrehschaltung werden dann noch in den Analogaddierern 23 den Bahnkurvensignalen $x_b$, $y_b$ additiv unter Bildung der Ausgangssignale x und y überlagert, die zur Ansteuerung der Ablenkverstärker 17 der Elektronenstrahlschweißmaschine verwendet werden können. In der praktischen Realisierung können die Addierer 22 und 23 zu je einem Addierer mit je drei Analogeingängen verbunden werden.

In dem Bahnkurvengenerator 10 wird die vom Elektronenstrahl zu durchlaufende Bahnkurve als eine Folge von im Abstand voneinander angeordneten Stützpunkten vorgegeben. Die zugehörigen Koordinaten $x_i$, $y_i$ sowie weitere für die nachfolgend erläuterte Interpolation erforderlichen Stützpunktparameter werden in der Schaltungsanordnung 30, 60 vorzugsweise unter Verwendung eines Mikroprozessors berechnet oder aus einem Datenspeicher ausgelesen und in D/A-Wandlern in entsprechende Analogsignale umgewandelt. Damit sich der Elektronenstrahl auf dem Weg zwischen zwei Stützpunkten mit einer einstellbaren Geschwindigkeit bewegt, ist anhand der ausgegebenen Stützpunktparameter eine Interpolation erforderlich, die in einer hierfür vorgesehenen Interpolationsschaltung vorgenommen wird.

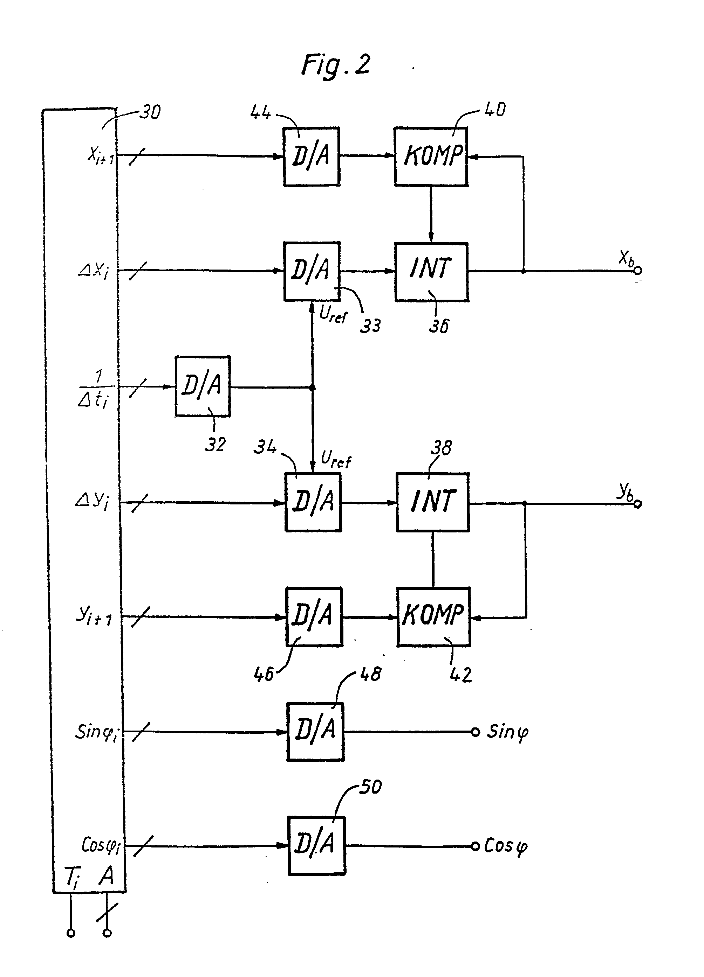

Im Falle des in Fig. 2 gezeigten Ausführungsbeispiels eines Bahnkurvengenerators 10 werden von der Schaltungsanordnung 30 im Zeitpunkt $t_i$, an dem sich der Strahl am Stützpunkt $x_i$, $y_i$ befindet, die Koordinatenwerte des folgenden Stützpunkts $x_{i+1}$, $y_{i+1}$, die Koordinatendifferenzwerte $\Delta x_i$, $\Delta y_i$ sowie ein Wert ausgegeben, der umgekehrt proportional zu dem vorgegebenen Zeitintervall $\Delta t_i$ ist, in dem der Strahl die Strecke zwischen den beiden Stützpunkten durchläuft. Das Signal $1/\Delta t_i$ wird in einem D/A-Wandler 32 in ein Analogsignal umgewandelt, das als Referenzspannung für je einen multiplizierenden D/A-Wandler 33, 34 dient, an dessen Digitaleingang die Differenzwerte $\Delta x_i$ bzw. $\Delta y_i$ gelegt sind. Die Ausgangssignale sind aufgrund der multiplizierenden Wirkung der D/A-Wandler 33, 34 proportional zu $\Delta x_i/\Delta t_i$ bzw. $\Delta y_i/\Delta t_i$. Sie werden in den Integrierern 36, 38 von dem zur Ausgangskoordinate $x_i$ bzw. $y_i$ proportionalen Ausgangswert aus über die Zeit integriert, so daß sich am Ausgang der Integrierer 36, 38 ein zeitlich linearer Spannungsverlauf ergibt. Die Ausgangsspannung der Integrierer 36, 38 wird mit Hilfe der Komparatoren 40, 42 mit der zu den Koordinaten $x_{i+1}$ bzw. $y_{i+1}$ Proportionalen Ausgangsspannung der D/A-Wandler 44, 46 verglichen. Sobald die betreffenden Spannungen übereinstimmen, werden die Integrierer 36, 38 von ihrem Eingang abgetrennt, so daß sie als Haltekreise auf ihrer momentanen Ausgangsspannung gehalten werden. An den Ausgängen der Integrierer 36, 38 können die interpolierten Bahnkurvensignale $x_b$, $y_b$ abgegriffen werden.

Weiter wird von der Schaltungsanordnung 30 für jeden Stützpunkt der sin- und cos-Wert des Winkels $\varphi_i$ ausgegeben, den die Normale der Bahnkurve in dem betreffenden Stützpunktintervall mit der x-Achse des zugehörigen Koordinatensystems einschließt. Diese Signale werden in den D/A-Wandlern 48, 50 in die entsprechenden Analogsignale $\sin\varphi$, $\cos\varphi$ umgewandelt, die am Ausgang des Bahnkurvengenerators abgegriffen werden können.

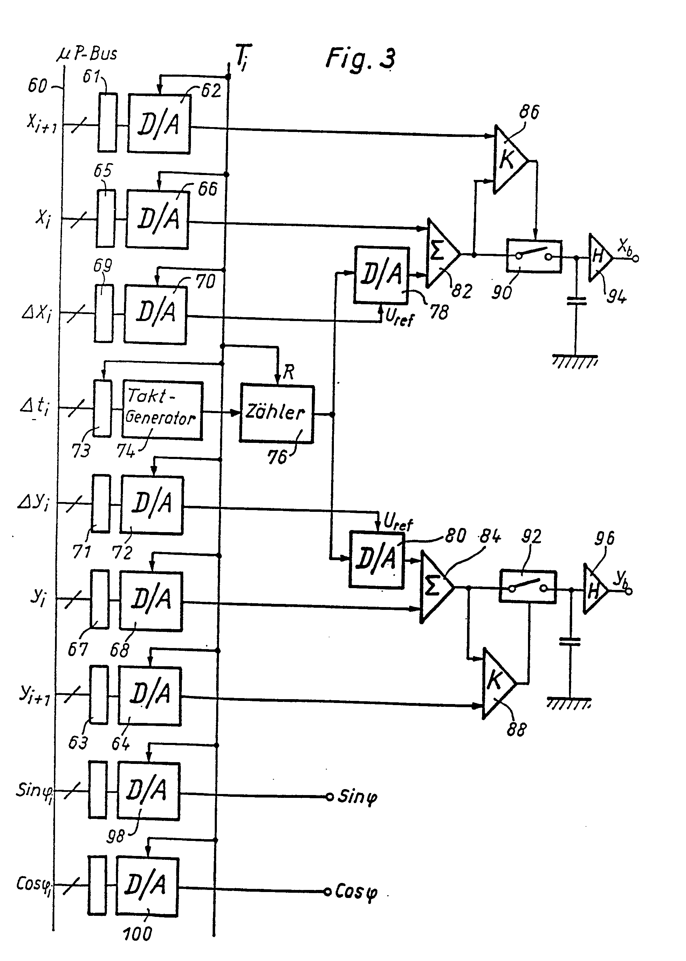

Bei dem in Fig. 3 gezeigten Ausführungsbeispiel eines Bahnkurvengenerators 10 werden von der mikroprozessorgesteuerten Schaltungsanordnung im Zeitpunkt $t_i$ an die D/A-Wandler 62, 64 die Koordinatenwerte $x_{i+1}$, $y_{i+1}$, die zum Zeitpunkt $t_{i+1}$ erreicht werden sollen, an die D/A-Wandler 66, 68 die Koordinatenwerte $x_i$, $y_i$, die zum Zeitpunkt $t_i$ vorhanden sein sollen, an die D/A-Wandler 70, 72 die Differenz der Koordinatenwerte $\Delta x_i$, $\Delta y_i$ jeweils aus den zugehörigen Pufferspeichern 61, 63, 65, 67, 69, 71 übertragen. Weiter wird an den digitalen Pufferspeicher 73 ein Zeitintervallsignal $\Delta t_i$ übertragen, mit dem sich die Frequenz des Taktgenerators 74 so steuern läßt, daß in der Zeit $\Delta t_i$ n Taktimpulse ausgegeben werden.

Gleichzeitig mit dem Übernahmeimpuls $T_i$ für die D/A-Wandler wird der vom Taktgenerator 74 angesteuerte Zähler 76 auf Null zurückgesetzt. Der Zählausgang des Zählers 76 ist mit zwei multiplizierenden D/A-Wandlern 78, 80 verbunden, deren Referenzspannung von den D/A-Wandlern 70, 72 erzeugt wird. Mit jedem Zählschritt erhöht sich somit die Ausgangsspannung des D/A-Wandlers 78, 80 um $1/n\Delta x_i$ bzw. $1/n\Delta y_i$, so daß nach n Zählschritten der Spannungswert $\Delta x_i$ bzw. $\Delta y_i$ erreicht wird. In je einem Analogaddierer 82, 84 wird zu diesem Signal das den Werten $x_i$ bzw. $y_i$ entsprechende Ausgangssignal hinzuaddiert, so daß am Ausgang der Addierer 82, 84 eine von $x_i$ bzw. $y_i$ ausgehende treppenförmige Spannung entsteht, die zum Zeitpunkt $t_{i+1}$ den Wert $x_{i+1}$ bzw. $y_{i+1}$ erreicht. Je ein Komparator 86, 88 vergleicht die betreffenden Spannungswerte mit dem Ausgangswert der D/A-Wandler 62 bzw. 64 und unterbricht über je einen elektronischen Schalter 90, 92 die Verbindung zu einem Haltekreis 94, 96, sobald der neue Wert $x_{i+1}$, $y_{i+1}$ erreicht ist. Am Ausgang der Haltekreise werden die Werte $x_{i+1}$ bzw. $y_{i+1}$ im Anschluß daran so lange gehalten, bis die Pufferspeicher 61, 63, 65, 67, 69, 71 neu geladen sind.

Die interpolierten Bahnkurvensignale $x_b$, $y_b$ sind am Ausgang der Haltekreise 94, 96 abgreifbar.

Weiterhin sind auch bei diesem Bahnkurvengenerator die die Richtung der Bahnkurvennormalen definierenden Richtungssignale $\sin\varphi$ und $\cos\varphi$ abgreifbar, die durch den Mikroprozessor in jedem Stützpunkt digital vorgegeben und in den D/A-Wandlern 98, 100 in Analogsignale umgesetzt werden.

Die in Fig. 1 gezeigte Schaltungsanordnung enthält ferner eine Einrichtung zur Strahlnachführung 16, mit deren Hilfe Toleranzen bei der Positionierung des Werkstücks sowie Abweichungen der vorgegebenen Bahnkurve $x_b$, $y_b$ gegenüber dem zu bearbeitenden Schweißspalt automatisch ausgeglichen werden können. Die Strahlnachführung erfordert eine Abtastung der Werkstückoberfläche, mittels der die Lageabweichung des Schweißspalts auf dem Werkstück von der vorgegebenen Bahnkurve ermittelt wird. Es bedarf dazu eines Meßvorgangs vor dem eigentlichen Schweißvorgang, der über die zentrale Maschinenablaufsteuerung ausgelöst wird.

Zur Abtastung wird der Elektronenstrahl der Schweißmaschine verwendet, gegebenenfalls nach vorheriger Herabsetzung der Strahlintensität. Gemessen werden dabei die an der Werkstückoberfläche reflektierten Elektronen mit Hilfe einer elektrisch isoliert in der Schweißkammer angeordneten Auffangelektrode 24. Bewegt man den Elektronenstrahl senkrecht zum Schweißspalt über die Werkstückoberfläche und mißt dabei mit der Auffangelektrode 24 die Anzahl der von der Metalloberfläche reflektierten Elektronen, so vermindert sich zu dem Zeitpunkt, zu dem der Elektronenstrahl ganz oder teilweise in den Spalt fällt, die Zahl der die Auffangelektrode 24 erreichenden Elektronen, weil die innerhalb des Spalts reflektierten Elektronen zum größten Teil von den Spaltwänden absorbiert werden. Die Zahl der zur Auffangelektrode gelangenden Elektronen wird mit Hilfe der am Arbeitswiderstand 25 abfallenden Spannung gemessen. Das im Verlauf einer Bewegung des Abtaststrahls quer zum Spalt erhaltene Spannungsminimum kennzeichnet somit die Position des Spalts relativ zur vorgegebenen Bahnkurve. Die für den Meßvorgang erforderliche Hin- und Herbewegung des Elektronenstrahls quer zur Bahnkurve erfolgt über das im Ablenkgenerator 14 erzeugte Ablenksignal $y_a$, das in der Koordinatendreheinrichtung 18 im Verlauf der Bahnkurve ständig nach der Bahnkurvennormalen ausgerichtet wird.

Die gemessenen Positionsdaten werden in der Schaltungsanordnung 26 ausgewertet und in digitaler Form in dem Speicher so abgespeichert, daß jedem Stützpunkt der Bahnkurve ein Korrekturwert $y_{ki}$ zugeordnet ist. Die Adressierung des Speichers und die Übernahme der Speicherwerte wird dementsprechend vom Bahnkurvengenerator aus gesteuert.

Bei einem anschließenden Schweißvorgang, bei dem der Kanalumschalter 20 auf den Pendelgenerator 12 geschaltet wird, werden die Korrekturwerte $y_{ki}$ stützpunktweise aus dem Speicher 27 ausgelesen, in einem D/A-Wandler 28 in ein entsprechendes Analogsignal umgewandelt und über einen Analogaddierer 29, an dessen zweitem Eingang der $y_p$-Wert des Pendelgenerators 12 anliegt, der Koordinatendreheinrichtung 18 zugeleitet. Auf diese Weise wird erreicht, daß die Korrektursignale $y_k$ - wie auch schon während des Meßvorgangs die Ablenksignale $y_a$ - immer in der Normalenrichtung überlagert werden.

## Patentansprüche

1. Anordnung zum Bearbeiten, insbesondere Schweißen eines Werkstücks mittels eines fokussierten Elektronenstrahls in einer Elektronenstrahlbearbeitungsmaschine, insbesondere einer Elektronenstrahl-Schweißmaschine, mit einem Bahnkurvengenerator (10) zur Bewegung des Auftreffpunkts des Elektronenstrahls entlang einer Bahnkurve relativ zum Werkstück, dadurch gekennzeichnet, daß der Bahnkurvengenerator eine Schaltungsanordnung (30) zur sequentiellen Ausgabe der digitalen Koordinatenwerte ($x_i$, $y_i$) der Bahnkurven-Stützpunkte, je einen eingangsseitig mit dem zugehörigen Koordinatenwerten beaufschlagten Digital-Analog-Wandler (44, 46) zur Erzeugung eines entsprechenden analogen Stützpunktsignals und eine Interpolationsschaltung zur Erzeugung eines mit vorgegebener Geschwindigkeit stetig oder schrittweise zwischen dem Pegel zweier aufeinanderfolgender Stützpunktsignale variierenden Bahnkurvensignals für die Ansteuerung je eines Ablenkverstärkers (17) der Elektronenstrahlbearbeitungsmaschine umfaßt, und daß die Interpolationsschaltung je einen, einer der beiden Koordinaten zugeordneten D/A-Wandler (33, 34) aufweist, an dessen Digitaleingang der Differenzwert ($\Delta x_i$, $\Delta y_i$) der jeweils aufeinanderfolgenden Stützpunktkoordinaten anlegbar und mit einer zu einem vorgegebenen Zeitintervall ($\Delta t_i$) umgekehrt proportionalen Referenzspannung beaufschlagbar ist, und dessen Ausgang mit dem Eingang eines Integrierers (36, 38) verbunden ist, an dessen Ausgang das Bahnkurvensignal ($x_b$, $y_b$) abgreifbar ist.

2. Anordnung zum Bearbeiten, insbesondere Schweißen eines Werkstücks mittels eines fokussierten Elektronenstrahls in einer Elektronenstrahlbearbeitungsmaschine, insbesondere einer Elektronenstrahl-Schweißmaschine, mit einem Bahnkurvengenerator (10) zur Bewegung des Auftreffpunkts des Elektronenstrahls entlang einer Bahnkurve relativ zum Werkstück, dadurch gekennzeichnet, daß der Bahnkurvengenerator (10) eine Schaltungsanordnung (60) zur sequentiellen Ausgabe der digitalen Koordinatenwerte ($x_i$, $y_i$) der Bahnkurvenstützpunkte, je einen eingangsseitig mit den zugehörigen Koordinatenwerten beaufschlagten Digital/Analog-Wandler (66, 68) zur Erzeugung eines entsprechenden analogen Stützpunktsignals und eine Interpolationsschaltung zur Erzeugung eines mit vorgegebener Geschwindigkeit stetig oder schrittweise zwischen dem Pegel zweier aufeinanderfolgender Stützpunktsignale variierenden Bahnkurvensignals für die Ansteuerung je eines Ablenkverstärkers (17) der Elektronenstahlbearbeitungsmaschine umfaßt, und daß die Interpolationsschaltung einen Zähler (76) aufweist, dessen Takteingang mit einer zu einem vorgegebener Zeitintervall ($\Delta t_i$) umgekehrt proportionalen Taktfrequenz ansteuerbar ist, dessen Zählausgang mit dem Digitaleingang je eines den Stützpunktkoordinaten zugeordneten, multiplizierenden D/A-Wandlers (78, 80) verbunden ist, der mit einer zum Differenzwert ($\Delta x_i$, $\Delta y_i$) zweier aufeinanderfolgender Stützpunktkoordinaten proportionalen Referenzspannung beaufschlagbar ist und dessen Ausgangssignal auf den einen Eingang eines am anderen Eingang mit dem zum vorhergehenden Stützpunkt ($x_i$, $y_i$) gehörenden Stützpunktsignal beaufschlagbaren Addierer (82, 84) gelegt ist, an dessen Ausgang das Bahnkurvensignal ($x_b$, $y_b$) über ein Halteglied (94) abgreifbar ist.

3. Anordnung nach Anspruch 1, dadurch gekennzeichnet, daß die Ausgänge der Integrierer (36, 38) mit dem Eingang je eines Komparators (40, 42) verbunden ist, dessen zweiter Eingang mit dem Ausgang des mit dem jeweiligen Koordinatenwert des folgenden Stützpunktes ($x_{i+1}$, $y_{i+1}$) beaufschlagten D/A-Wandlers (44, 46) verbunden ist, und daß jeder Integrierer (36, 38) durch Ausgangssignal des zugehörigen Komparators (40, 42) unter Bildung eines Haltekreises von seinem Eingang abtrennbar ist.

4. Anordnung nach Anspruch 2, dadurch gekennzeichnet, daß der Takteingang des Zählers (76) durch einen Taktgenerator (74) mit durch den vorgegebenen Zeitintervallwert ($\Delta t_i$) einstellbarer Taktfrequenz ansteuerbar ist

5. Anordnung nach Anspruch 2 oder 4, dadurch gekennzeichnet, daß der Ausgang der Addierer (82, 84) mit dem einen Eingang je eines Komparators (86, 88) verbunden ist, dessen zweiter Eingang mit dem Ausgang des mit dem Koordinatenwert ($x_{i+1}$, $y_{i+1}$) des folgenden Stützpunkts beaufschlagten D/A-Wandlers (62, 64) verbunden ist, daß der Ausgang der Addierer weiter über je einen elektronischen Schalter (90, 92) mit dem Eingang eines Haltekreises (94, 96) verbunden ist, und daß die elektronischen Schalter (90, 92) durch das Ausgangssignal des zugehörigen Komparators (86, 88) ansteuerbar sind.

6. Anordnung nach einem der Ansprüche 1 bis 5, gekennzeichnet durch eine Schaltungsanordnung (30, 60) zur Erzeugung je eins zum momentanen Richtungssinus ($\sin\varphi_i$) und Richtungscosinus ($\cos\varphi_i$) der Bahnkurve proportionalen Richtungssignals ($\sin\varphi$, $\cos\varphi$), eine mit den Richtungssignalen und mit den zu den Koordinaten einer Modulationskurve proportionalen Signalen ($x_m$, $y_m$) eines Modulationskurvengenerator beaufschlagbare Schaltungsanordnung (18) zur Drehung der Modulationskurvensignale in das durch die Richtungssignale definierte Koordinatensystem, sowie eine mit den Bahnkurvensignalen ($x_b$, $y_b$) und den gedrehten Modulationskurvensignalen ($x'$, $y'$) beaufschlagte Schaltung (23) zur additiven Überlagerung dieser Signale, deren Ausgänge mit den Ablenkverstärkern (17) der Elektronenstrahlbearbeitungsmaschine verbindbar sind.

7. Anordnung nach Anspruch 6, dadurch gekennzeichnet, daß die Schaltungsanordnung (18) für die Drehung der Modulationskurvensignale vier Analogmultiplizierer aufweist, deren Eingänge paarweise mit je einem der Richtungssignale ($\sin\varphi$, $\cos\varphi$) und einem der Modulationskurvensignale ($x_m$, $y_m$) beaufschlagt und deren Ausgänge mit je einem Eingang zweier Analogaddierer (21) zur Erzeugung je eines Ausgangssignals ($x'$, $y'$) nach Maßgabe der folgenden Signalverknüpfung verbunden sind:

$$x' = x_m \cos\varphi - y_m \sin\varphi$$
$$y' = x_m \sin\varphi + y_m \cos\varphi$$

wobei $\varphi$ den zwischen der momentanen Bahnkurvennormalen und der x-Achse des Koordinatensystems der Bahnkurve eingeschlossenen Winkel bedeutet.

8. Anordnung nach Anspruch 6, dadurch gekennzeichnet, daß die Schaltungsanordnung (18) für die Drehung der Modulationskurvensignale

vier Analogmultiplizierer (21) aufweist, deren Eingänge paarweise mit je einem der Richtungssignale (sinψ und cosψ) und einem der Modulationskurvensignale ($x_m$, $y_m$) beaufschlagt und deren Ausgänge mit je einem Eingang zweier Analogaddierer (22) zur Erzeugung eines Ausgangssignals nach Maßgabe der folgenden Signalverknüpfungen verbunden sind:

$$x' = - x_m \sin\psi + y_m \cos\psi$$
$$y' = x_m \cos\psi + y_m \sin\psi$$

wobei ψ den zwischen der momentanen Bahnkurventangente und der x-Achse des Koordinatensystems der Bahnkurve eingeschlossenen Winkel bedeutet.

9. Anordnung nach einem der Ansprüche 1 bis 8 mit einer Vorrichtung zum Auffangen des an der Werkstückoberfläche reflektierten, quer zur vorgegebenen Bahnkurve mit einem Ablenksignal modulierten Abtaststrahls zur Erzeugung eines die Lage einer Bearbeitungslinie, insbesondere eines Schweißspalts, bezüglich der vorgegebenen Bahnkurve definierenden Positionssignals, einer elektronischen Anordnung zur Auswertung des Positionssignals und Abspeicherung der dabei gewonnenen Positionsdaten sowie einer Anordnung zur Lagekorrektur des Elektronenstrahlauftreffpunkts beim Schweißvorgang nach Maßgabe der abgespeicherten Positionswerte, *dadurch gekennzeichnet*, daß der Modulationskurvengenerator einen Pendelgenerator (12) für die Erzeugung eines dem Elektronenstrahl beim Schweißvorgang zu überlagernden Pendelsignals ($x_p$, $y_p$) und einen Ablenkgenerator (14) für die Erzeugung eines Ablenksignals ($y_a$) enthält, daß die Modulationssignaleingänge der Koordinatendrehschaltung (18) über einen Kanalumschalter (20) wahlweise mit dem Pendelsignal oder mit dem Ablenksignal als Modulationskurvensignal ($x_m$, $y_m$) beaufschlagbar sind, und daß zu jedem Stützpunkt ($x_i$, $y_i$) ein für die Lagekorrektur bestimmter Korrekturwert ($y_{ki}$) in einer Speicheranordnung (27) abspeicherbar ist.

10. Anordnung nach Anspruch 9, *dadurch gekennzeichnet*, daß die Speicheranordnung für die Stützpunktwerte ($x_i$, $y_i$; $\Delta x_i$; $\Delta t_i$) und die Speicheranordnung für die Korrekturwerte ($y_{ki}$) synchron ein- und auslesbar sind.

11. Anordnung nach einem der Ansprüche 1 bis 10 gekennzeichnet durch einen Analogaddierer (29), dessen einer Eingang mit dem Ausgang ($y_k$) eines mit dem Korrekturwertspeicher verbundenen D/A-Wandlers und dessen zweiter Eingang mit einem der beiden Koordinatenausgänge ($y_p$) des Pendelgenerators verbunden ist, und dessen Ausgang über den Kanalumschalter mit dem betreffenden Modulationssignaleingang ($y_m$) der Koordinatendrehschaltung (18) verbindbar ist.

## Claims

1. An arrangement for processing, more particularly for welding, a workpiece using a focused electron beam in an electron beam processing machine, more particularly an electron beam welding machine, with a path generator (10) for moving the point of impact of the electron beam along a path relative to the workpiece, characterised in that the path generator incorporates a circuit arrangement (30) for sequentially issuing the digital coordinate values ($x_i$, $y_i$) of the path support points; a respective digital-to-analogue converter (44, 46), to the input side of which are applied the associated coordinate values, for generating a corresponding analogue support signal; and an interpolation circuit for generating a path signal that varies constantly or stepwise at a present speed between the levels of two successive support point signals for actuating a respective deflection amplifer (17) of the electron beam processing machine, and in that the interpolation circuit has a respective D/A converter (33, 34) associated with one of the two coordinates, at the digital input of the differential value ($\Delta x_i$, $\Delta y_i$) of the respective successive support point coordinates can be applied and across which a reference voltage can be passed that is inversely proportional at a preset time interval ($\Delta t_i$), and the output of which is connected to the input of an integrator (36, 38), at the output of which the path signal ($x_b$, $y_b$) can be sampled.

2. An arrangement for processing, more particularly for welding, a workpiece using a focused electron beam in an electron beam processing machine, more particularly an electron beam welding machine, with a path generator (10) for moving the point of impact of the electron beam along a path relative to the workpiece, characterised in that the path generator (10) incorporates a circuit arrangement (60) for sequentially issuing the digital coordinate values ($x_i$, $y_i$) of the path support points; a respective digital-to-analogue converter (66, 68), to the input side of which are applied the associated coordinate values, for generating a corresponding analogue support point signal; and an interpolation circuit for generating a path signal that varies constantly or stepwise at a preset speed between the levels of two successive support point signals for actuating a respective deflection amplifier (17) of the electron beam processing machine, and in that the interpolation circuit has a counter (76), the clock pulse input of which can be controlled at a clock pulse frequency inversely proportional to a preset time interval ($\Delta t_i$), the counting output of which is connected to the digital input of a respective multiplicative D/A converter (78, 80) associated with the support point coordinates, across which D/A converter can be applied a reference voltage proportional to the differential value ($\Delta x_i$, $\Delta y_i$) of two successive support point coordinates, and the output signal of which D/A converter is applied to one input of an adder (82, 84), to the other input of which the support point signal belonging to the preceding support point ($x_i$, $y_i$) can be applied, at the output of which adder the path signal ($x_b$, $y_b$) can be sampled by means of a holding element (94).

3. The arrangement according to claim 1, characterised in that the outputs of the integrators (36, 38) are connected to the input of a respective comparator (40, 42), the second input of which is connected to the output of the D/A converter (44, 46) to which the respective coordinate value of the following support point ($x_{i+1}$, $y_{i+1}$) is applied, and in that each integrator (36, 38) can be disconnected from its input by the output signal from the associated comparator (40, 42) to form a holding circuit.

4. The arrangement according to claim 2, characterised in that the clock pulse input of the counter (76) can be actuated by a clock pulse generator (74) at a clock pulse frequency adjustable by the preset timing interval value ($\Delta_i$).

5. The arrangement according to claim 2 or 4, characterised in that the output of the adders (82, 84) is connected to one input of a respective comparator (86, 88), the second input of which is connected to the output of the D/A converter (62, 64) to which the coordinate value ($x_{i+1}$, $y_{i+1}$) of the following support point is applied, that the output of the adders is further connected via a respective electronic switch (90, 92) to the input of a holding circuit (94, 96), and that the electronic switches (90, 92) can be actuated by the output signal from the associated comparator (86, 88).

6. The arrangement according to one of claims 1 to 5, characterised by a circuit arrangement (30, 60) for generating a respective direction signal (sinφ, cosφ) proportional to the momentary direction sine (sinφ) and direction cosine (cosφ) of the path; a circuit arrangement (18) to which the direction signals and the signal ($x_m$, $y_m$) from a modulation contour generator proportional to the coordinates of a modulation contour can be applied to rotate the modulation contour signals into the system of coordinates defined by the direction signals; and a circuit (23) to which the path signals ($x_b$, $y_b$) and the rotated modulation contour signals (x', y') can be applied for additively superimposing said signals, the outputs of which can be connected to the deflection amplifiers (17) of the electron beam processing machine.

7. The arrangement according to claim 6, characterised in that the circuit arrangement (18) for rotation of the modulation contour signals has four analogue multipliers, to the inputs of which are applied pairwise a respective one of the direction signals (sinφ, cosφ) and one of the modulation contour signals ($x_m$, $y_m$), and the outputs of which are connected to a respective input of two analogue adders (21) for generating a respective output signal (x', y') according to the following signal combination:

$$x' = x_m \cos\varphi - y_m \sin\varphi$$
$$y' = x_m \sin\varphi - y_m \cos\varphi$$

where φ denotes the angle enclosed between the momentary normal to the path and the x axis of the system of coordinates of the path.

8. The arrangement according to claim 6, characterised in that the circuit arrangement (13) for rotating the modulation contour signals has four analogue multipliers (21), to the inputs of which are applied pairwise a respective one of the direction signals (sinψ and cosψ) and one of the modulation contour signals ($x_m$, $y_m$), and the outputs of which are connected to a respective input of two analogue adders (22) for generating an output signal according to the following signal combinations:

$$x' = -x_m \sin\psi + y_m \cos\psi$$
$$y' = x_m \cos\psi + y_m \sin\psi$$

where ψ denotes the angle enclosed between the momentary tangent to the path and the x axis of the system of coordinates of the path.

9. The arrangement according to one of claims 1 to 8, with an apparatus for capturing the scanning beam reflected at the workpiece surface and modulated transverse to the set path with a deflection signal for generating a position signal defining the position of a processing line, more particularly a weld joint, in relation to the set path; with an electronic arrangement for evaluating the position signal and storing the positional data thereby obtained; and with an arrangement for correcting the position of the electron beam impact point during the welding operation according to the stored positional values, characterised in that the modulation contour generator contains a pendulum generator (12) for generating a pendulum signal ($x_p$, $y_p$) to be superimposed on the electron beam during the welding operation and a deflection generator (14) for generating a deflection signal ($y_a$), that the pendulum signal or the deflection signal can be applied selectively to the modulation signal inputs of the cordinate rotating circuit (18) as a modulation contour signal ($x_m$, $y_m$) via a channel changer (20), and that at each support point ($x_i$, $y_i$) a correction value ($y_{ki}$) intended for position correction can be stored in a storage arrangement (27).

10. The arrangement according to claim 9, characterised in that the storage arrangement for the support point values ($x_i$, $y_i$; $\Delta x_i$; $\Delta t_i$) and the storage arrangement for the correction values ($y_{ki}$) can be read in and out synchronously.

11. The arrangement according to one of claims 1 to 10, characterised by an analogue adder (29), one input of which is connected to the output ($y_k$) of a D/A converter connected to the correction value store and the second input of which is connected to one of the two coordinate outputs ($y_p$)

of the pendulum generator, and the output of which can be connected via the channel changer to the relevant modulation signal input ($y_m$) of the coordinate rotation circuit (18).

**Revendications**

1. Dispositif pour l'usinage, en particulier le soudage d'une pièce à usiner au moyen d'un faisceau électronique focalisé dans une machine d'usinage par faisceau électronique, en particulier une machine à souder par bombardement électronique, avec un générateur de trajectoire (10) pour le déplacement du point d'impact du faisceau électronique le long d'une trajectoire par rapport à la pièce à usiner, *caractérisé en ce* que le générateur de trajectoire comprend un circuit (30) pour la sortie séquentielle des valeurs de coordonnées numériques ($x_i$, $y_i$) des points d'appui de trajectoire, respectivement un convertisseur numérique-analogique (44, 46) recevant du côté entrée les valeurs de coordonnées associées et destiné à générer un signal de point d'appui analogique correspondant, et un circuit d'interpolation pour la génération d'un signal de trajectoire pour l'excitation de respectivement un amplificateur de déviation (17) de la machine d'usinage par faisceau électronique, qui varie à la vitesse prédéterminée, en continu ou par pas, entre le niveau de deux signaux de point d'appui consécutifs, et que le circuit d'interpolation comporte respectivement un convertisseur D/A (33, 34) associé à l'une des deux coordonnées à l'entrée numérique duquel peut être appliquée la valeur différentielle ($\Delta x_i$, $\Delta y_i$) des coordonnées des points d'appui respectivement consécutifs ainsi qu'une tension de référence inversement proportionnelle à un intervalle de temps prédéterminé ($\Delta t_i$) et dont la sortie est reliée à l'entrée d'un intégrateur (36, 38) sur la sortie duquel peut être prélevé le signal de trajectoire ($x_b$, $y_b$).

2. Dispositif pour l'usinage, en particulier le soudage d'une pièce à usiner au moyen d'un faisceau électronique focalisé dans une machine d'usinage par faisceau électronique, en particulier une machine à souder par bombardement électronique, avec un générateur de trajectoire (10) pour le déplacement du point d'impact du faisceau électronique le long d'une trajectoire par rapport à la pièce à usiner, caractérisé en ce que le générateur de trajectoire (10) comprend un circuit (60) pour la sortie séquentielle des valeurs de coordonnées numériques ($x_i$, $y_i$) des points d'appui de trajectoire, respectivement un convertisseur numérique-analogique (66, 68) recevant du côté entrée les valeurs de coordonnées associées et servant à générer un signal d'appui analogique correspondant, et un circuit d'interpolation pour la génération d'un signal de trajectoire pour l'excitation de respectivement un amplificateur de déviation (17) de la machine d'usinage par faisceau électronique, qui varie à la vitesse prédéterminée, en continu ou par pas, entre le niveau de deux signaux de point d'appui consécutifs, et que le circuit d'interpolation comporte un compteur (76) dont l'entrée de synchronisation peut être commandée par une fréquence horloge inversement proportionnelle à un intervalle de temps prédéterminé ($\Delta t_i$), dont la sortie de comptage est reliée à l'entrée numérique de respectivement un convertisseur D/A (78, 80) de multiplication associé aux coordonnées des points d'appui à laquelle peut être appliquée une tension de référence proportionnelle à la valeur différentielle ($\Delta x_i$, $\Delta y_i$) de deux coordonnées de points d'appui consécutifs et dont le signal de sortie est transmis à l'une des entrées d'un additionneur (82, 84) à l'autre entrée duquel peut être appliqué le signal de point d'appui correspondant au point d'appui précédent ($x_i$, $y_i$) et à la sortie duquel le signal de trajectoire ($x_b$, $y_b$) peut être prélevé par l'intermédiaire d'un circuit de maintien (94).

3. Dispositif selon la revendication 1, caractérisé en ce que les sorties des intégrateurs (36, 38) sont reliées à l'entrée de respectivement un comparateur (40, 42) dont la deuxième entrée est reliée à la sortie du convertisseur D/A (44, 46) recevant respectivement la valeur de coordonnée du point d'appui suivant ($x_{i+1}$, $y_{i+1}$), et que chaque intégrateur (36, 38) peut être séparé de son entrée par le signal de sortie du comparateur associé (40, 42) avec formation d'un circuit de maintien.

4. Dispositif selon la revendication 2, caractérisé en ce que l'entrée de synchronisation du compteur (76) peut être commandée par une horloge (74) avec une fréquence horloge réglable par la valeur de l'intervalle de temps prédéterminé ($\Delta t_i$).

5. Dispositif selon la revendication 2 ou 4, caractérisé en ce que la sortie de l'additionneur (82, 84) est reliée à l'entrée de respectivement un comparateur (86, 88) dont la deuxième entrée est reliée à la sortie du convertisseur D/A (62, 64) recevant la valeur de coordonnée ($x_{i+1}$, $y_{i+1}$) du point d'appui suivant, que la sortie des additionneurs est reliée, en outre, par l'intermédiaire de respectivement un commutateur électronique (90, 92), à l'entrée d'un circuit de maintien (94, 96), et que les commutateurs électroniques (90, 92) peuvent être commandés par le signal de sortie du comparateur (86, 88) associé.

6. Dispositif selon l'une des revendications 1 à 5, caractérisé en ce qu'il comprend un circuit (30, 60) pour la génération d'un signal de direction ($\sin\varphi$, $\cos\varphi$) respectivement proportionnel au sinus de direction ($\sin\varphi_i$) et au cosinus de direction ($\cos\varphi_i$) momentanés de la trajectoire, un circuit (18) auquel peuvent être transmis les signaux de direction et les signaux ($x_m$, $y_m$) d'un générateur de courbes de modulation proportionnels aux coordonnées d'une courbe de modulation pour la rotation des signaux de courbe de modulation dans le système de coordonnées défini par les signaux de direction, ainsi qu'un circuit (23) recevant les signaux de trajectoire ($x_b$, $y_b$) et les signaux de courbe de modulation tournés (x', y') et servant à la superposition additive de ces signaux, dont les sorties peuvent être reliées aux amplificateurs de déviation (17) de la machine d'usinage par faisceau électronique.

7. Disposition selon la revendication 6, caractérisé en ce que le circuit 18 pour la rotation des signaux de courbe de modulation comprend quatre multiplicateurs analogiques dont les entrées peuvent recevoir par paires respectivement l'un des signaux de direction ($\sin\varphi$, $\cos\varphi$) et l'un des signaux de courbe de modulation ($x_m$, $y_m$) et dont les sorties sont reliées à respectivement une entrée de deux additionneurs analogiques (21) pour la génération de respectivement un signal de sortie (x', y') en fonction de l'enchaînement suivant des signaux:

$$x' = x_m \cos\varphi - y_m \sin\varphi$$
$$y' = x_m \sin\varphi + y_m \cos\varphi$$

$\varphi$ indiquant l'angle formé par la normale momentanée à la trajectoire et l'axe x du système de coordonnées de la trajectoire.

8. Dispositif selon la revendication 6, caractérisé en ce que le circuit (18) pour la rotation des signaux de courbe de modulation comprend quatre multiplicateurs analogiques (21) dont les entrées reçoivent par paire respectivement l'un des signaux de direction ($\sin\psi$ et $\cos\psi$) et l'un des signaux de courbe de modulation ($x_m$, $y_m$) et dont les sorties sont reliées à respectivement une entrée de deux additionneurs analogiques (22) pour la génération d'un signal de sortie en fonction des enchaînements suivants des signaux:

$$x' = -x_m \sin\psi + y_m \cos\psi$$
$$y' = x_m \cos\psi + y_m \sin\psi$$

$\psi$ indiquant l'angle formé par la tangente momentanée à la trajectoire et l'axe x du système de coordonnées de la trajectoire.

9. Dispositif selon l'une des revendications 1 à 8, avec un dispositif pour capter le faisceau d'exploration réfléchi à la surface de la pièce à usiner et modulé transversalement à la trajectoire prédéterminée avec un signal de déviation en vue de générer un signal de position qui définit la position d'une ligne d'usinage, en particulier d'une fente de soudage, par rapport à la trajectoire prédéterminée, un dispositif électronique pour l'interprétation et la mémorisation des données de position alors obtenues ainsi qu'un dispositif pour la correction de la position du point d'impact du faisceau électronique lors de l'opération de soudage en fonction des valeurs de position mémorisées, caractérisé en ce que le générateur de courbes de modulation comprend un alternateur pilote à aimants permanents (12) pour la génération d'un signal d'oscillation ($x_p$, $y_p$) à superposer au faisceau électronique lors de l'opération de soudage ainsi qu'un générateur de déviation (14) pour la génération d'un signal de déviation ($y_a$), qu'aux entrées de signaux de modulation du circuit de rotation de coordonnées (18) peuvent être appliqués, au choix, par l'intermédiaire d'un commutateur de canaux (20), le signal d'oscillation ou le signal de déviation en tant que signal de courbe de modulation ($x_m$, $y_m$), et qu'une valeur de correction ($y_{ki}$) destinée à la correction de position peut être stockée pour chaque point d'appui ($x_i$, $y_i$) dans une mémoire (27).

10. Dispositif selon la revendication 9, caractérisé en ce que la mémoire pour les valeurs des points d'appui ($x_i$, $y_i$; $\Delta x_i$; $\Delta t_i$) et la mémoire pour les valeurs de correction ($y_{ki}$) permettent des entrées et des sorties en synchronisme.

11. Dispositif selon l'une des revendications 1 à 10, caractérisé en ce qu'il comprend un additionneur analogique (29) dont l'une des entrées est reliée à la sortie ($y_k$) d'un convertisseur D/A relié à la mémoire de valeurs de correction, dont la deuxième entrée est reliée à l'une des deux sorties de coordonnées ($y_p$) de l'alternateur pilote à aimants permanents et dont la sortie peut être reliée par l'intermédiaire du commutateur de canaux à l'entrée de signaux de modulation ($y_m$) du circuit de rotation de coordonnées (18).

## Fig. 1

EP 0 109 524 B1

Fig. 2

Fig. 3